**Europäisches Patentamt**

**European Patent Office**

**Office européen des brevets**

(11) Publication number: **0 440 157 B1**

# EUROPEAN PATENT SPECIFICATION

(45) Date of publication of patent specification: **07.06.95** (51) Int. Cl.$^6$: **C23C 16/36**, C22C 29/04

(21) Application number: **91101128.6**

(22) Date of filing: **29.01.91**

(54) **Process for producing a surface-coated blade member for cutting tools.**

(30) Priority: **31.01.90 JP 21048/90**

(43) Date of publication of application:
**07.08.91 Bulletin 91/32**

(45) Publication of the grant of the patent:
**07.06.95 Bulletin 95/23**

(84) Designated Contracting States:
**DE ES FR GB IT SE**

(56) References cited:
**DE-A- 2 505 009**
**US-A- 3 807 008**
**US-A- 3 971 656**

(73) Proprietor: **MITSUBISHI MATERIALS CORPO-
RATION**
**6-1, Otemachi 1-chome**
**Chiyoda-ku**
**Tokyo (JP)**

(72) Inventor: **Yoshimura, Hironori,
c/oTokyo-Seisakusho**
**MITSUBISHI MATERIALS CORPORATION,**
**1-27-20,**
**Nishishinagawa,**
**Shinagawa-ku,**
**Tokyo (JP)**
Inventor: **Odani, Niro, c/oTokyo-Seisakusho**
**MITSUBISHI MATERIALS CORPORATION,**
**1-27-20,**
**Nishishinagawa,**
**Shinagawa-ku,**
**Tokyo (JP)**

(74) Representative: **Hansen, Bernd, Dr.
Dipl.-Chem. et al**
**Hoffmann, Eitle & Partner**
**Patent- und Rechtsanwälte,**
**Postfach 81 04 20**
**D-81904 München (DE)**

## Description

BACKGROUND OF THE INVENTION

Field of the Invention

The present invention pertains to a process for producing a surface-coated blade member or insert of cermet for cutting tools, which is further improved in wear resistance. More particularly, this invention pertains to a process for forming a reaction layer of titanium carbo-nitride (TiCN) on the cermet substrate of the blade member essentially without diffusion of binder metal atoms thereinto, by means of a chemical vapor deposition process at temperatures less than 900°C.

Prior Art

Conventionally, cermets, containing at least one metal of carbide, nitride and carbo-nitride of titanium (Ti), zirconium (Zr), hafnium (Hf), tantalum (Ta), niobium (Nb), Tungsten (W), molybdenum (Mo) and chromium (Cr) as hard phase-constituting component and iron family metals such as cobalt (Co), nickel (Ni) and so on as binder metals, have been extensively used to form blade members or inserts for finish cutting of steels.

Furthermore, the blade members or inserts having surface coatings, to increase wear resistance, composed of reaction layers of TiC, TiCN, etc., on the above cermet substrate, have been extensively used in recent years.

Such surfaces coatings are usually formed by a chemical vapor deposition process as disclosed in Japanese Patent Application published Laid-Open No. 57-79169, because surface coatings formed by a physical vapor deposition process are inferior in adhesive strength to the cermet substrate of the blade member.

As the conventional process for forming surface coatings of TiC on the conventional cermet substrate by the chemical vapor deposition process, it has been well known to form a reaction layer of TiC on the cermet substrate using reaction gas composed of 2% of $TiCl_4$, 2% of $CH_4$, and 96% of $H_2$ (% by volume) at a temperature of 1020°C under a pressure of 13300 Pa (100 Torr), as disclosed in Japanese Patent Application published Laid-Open No. 59-52704. This reaction was represented by the following formula:

$$TiCl_4 + CH_4 + 2H_2 \rightarrow TiC + 4HCl + 2H_2 \qquad (1)$$

Also, as the conventional process for forming surface coating of TiCN on the cermet substrate, it has been well known to form a reaction layer of TiCN using a reaction gas composed of 4% of $TiCl_4$, 3% of $CH_4$, 4% of $N_2$ and 89% of $H_2$ (% by volume) at a temperature of 1000°C under a pressure of 13300 Pa (100 Torr). This reaction was represented by the following formula:

$$TiCl_4 + CH_4 + 1/2N_2 + H_2 \rightarrow TiCN + 4HCl + H_2 \qquad (2)$$

In these conventional processes, because the chemical vapor depositions were carried out at high temperatures, 1020°C for forming the layer of TiC, and 1000°C for forming the layer of TiCN, a great deal of binder metal atoms of the cermet substrate were diffused into each reaction layer of TiC and TiCN during the chemical vapor deposition process. The presence of such diffused binder metal atoms in the formed coating lowered the wear resistance of the surface coating of TiC or TiCN. Therefore, the resultant blade members produced by the conventional process exhibited low wear resistance.

However, if instead the chemical vapor deposition process is carried out at a temperature less than 900°C to avoid diffusion of the binder metal atoms into the reaction layer, it is difficult to form a reaction layer of TiCN on the cermet substrate, because the activity of $CH_4$ gas or $N_2$ gas used as the reaction gas will be lowered and the reaction for forming the surface coating will not occur.

SUMMARY OF THE INVENTION

It is therefore an object of this invention to provide a process for producing blade members or inserts having surface coatings of titanium carbo-nitride on the cermet substrate essentially without diffusion of binder metals thereinto, by means of a chemical vapor deposition process at a temperature below 900°C, whereby the blade member or insert exhibits excellent wear resistance.

According to the present invention, there is provided a process for producing a surface-coated blade member for cutting tools, which includes the steps of preparing a cermet substrate, containing 70 to 95% by weight of carbo-nitride as a hard phase-constituting component; represented by the formula $(Ti_xM_y)$-$(C_uN_v)$, wherein M is at least one metal selected from the group consisting of metals in groups $IV_A$, $V_A$ and $VI_A$ of the Periodic Table, except for titanium, namely Zr, Hf, V, Nb, Ta, Cr, Mo, and W, and wherein x, y, u and v are molar ratios which satisfy relations of $0.5 \leqq x \leqq 0.95$, $0.05 \leqq y \leqq 0.5$, $0.2 \leqq u \leqq 0.8$, $0.2 \leqq v \leqq 0.8$, $x + y = 1$, and $u + v = 1$; and balance one or two metals selected from the group consisting of cobalt and nickel as a binder component; and forming at least one layer of titanium carbo-nitride with an average thickness of 0.5 to 20 $\mu$m by a chemical vapor deposition process on said cermet substrate at a temperature of 700 to 900°C, using reaction gas containing acetonitrile.

According to a second aspect of the invention, the above-mentioned reaction gas is a mixture of titanium tetrachloride, acetonitrile and hydrogen gases.

The above-mentioned process is able to produce a surface coating of TiCN extremely efficiently even in the low temperature range of 700 to 900°C, by means of using reaction gas containing $CH_3CN$ gas instead of $CH_4$ and $N_2$ gasses used in the conventional process. Furthermore, by the process according to this invention, it is possible to form a surface coating of TiCN on the cermet substrate essentially without diffusion of binder metal atoms thereinto. Therefore, the resultant blade member exhibits excellent wear resistance.

The content of the hard phase-constituting component in the cermet substrate is 70 to 95% by weight and the binder component in the cermet substrate is 5 to 30% by weight. If the content of the hard phase-constituting component is less than 70% and the content of the binder component exceeds 30%, wear resistance of the cermet substrate of TiCN is lowered. On the other hand, if the content of the hard phase-constituting component exceeds 95% and that of the binder component is less than 5%, the cermet substrate is susceptible to chipping.

The average thickness of the surface coating on the cermet substrate is 0.5 to 20 $\mu$m. If the thickness is less than 0.5$\mu$m, the surface coating does not posses desired wear resistance. On the other hand, if the thickness exceeds 20$\mu$m, the cutting edges of the blade member are susceptible to chipping.

The surface coating of TiCN is formed by chemical vapor deposition process, by using a gas mixture containing $CH_3CN$. This reaction is represented by the following formula:

$$TiCl_4 + CH_3CN + 5/2H_2 \rightarrow TiCN + 4HCl + CH_4 \qquad (3)$$

Comparing the reaction formula (2) in the conventional process with the above reaction formula (3), it is seen that a mixture gas containing $CH_3CN$ gas is used as a reaction gas in the process according to this invention, instead of $CH_4$ and $N_2$ gasses in the conventional process. If such a gas mixture is used, and if the temperature during the chemical vapor deposition process is less than 700°, the reaction layer of TiCN is not formed efficiently because the reaction rate is low. On the other hand, if the temperature exceeds 900°, the surface coating formed is lower in wear resistance because of the diffusion of a great deal of binder metal atoms of the cermet into the reaction layer of TiCN. Thus, the temperature in the chemical vapor deposition process is determined so as to be no less than 700° and to be no greater than 900° in order to obtain a blade member having desired wear resistance.

Furthermore, in this invention, reaction layers of TiN may be formed on and under the above reaction layer of TiCN by means of conventional process. In the conventional process, the reaction layer of TIN is formed by using reaction gas containing $N_2$ gas or $NH_3$ gas. The diffusion of the binder metal atoms of the cermet into the reaction layer of TiN occurs a little. But the wettability between the reaction layer of TiN and the cermet substrate is very low. Therefore, if the average thickness of the reaction layer of TiN is no more than 4 $\mu$m, the existence of the reaction layer of TiN in the surface coating does not affect the property of the resultant blade member in wear resistance.

The invention will be described in more detail with reference to the following examples.

EXAMPLE 1

Powders of TiN, TiC, TaC, WC, $Mo_2C$, NbC, ZrC, Co, Ni and Al, each having a predetermined average particle size of 1.0 to 2.5 $\mu$m, were prepared as starting materials. The starting materials were blended so as to have the composition as shown in TABLE 1, and were mixed together for 72 hours by ball mill under wet conditions. After drying the mixture, the mixture was compacted into a dense solid body by a pressure of 1.5 ton/cm². Then, the compacted body was sintered at a temperature of 1550°C for 90 minutes under a pressure of 3990 Pa (30 Torr) under an atmosphere of $N_2$ gas to form a cermet substrate having substantially the same composition as the cermet substrates A to D shown in TABLE 1.

Subsequently, the cermet substrates B prepared in this manner were subjected to form surface coating of TiCN having the thickness of 5 μm thereon by a chemical vapor deposition process under the conditions shown in TABLE 2 to produce blade members 1 to 5 according to this invention; blade members 1 and 2 were produced by a comparison process; and blade member 1 was produced by a conventional process. The constituents of the formed surface-coating of these blade members are shown in TABLE 2.

The blade members 1 to 5 produced according to this invention, the blade members 1 and 2 produced by a comparison process, and the blade member 1 produced by a conventional process, were each attached to a holder and subjected to a continuous cutting test to determine wear resistance. The conditions for the above continuous cutting test were as follows:

Workpiece: a bar of steel (JIS-SCM415; Hardness; HB150)

Cutting speed: 250 m/minute

Feed rate: 0.2 mm/revolution

Depth of cut: 1.0 mm

Time of cutting: 30 minutes

Cutting oil: none

After this continuous cutting test, the flank wear of each blade member was observed. The results obtained are shown in TABLE 2.

As seen from TABLE 2, the binder metals of the cermet did not essentially diffuse into the surface coating of TiCN on each cermet substrate of blade members 1 to 5. Therefore, the blade members 1 to 5 exhibited excellent wear resistance.

In comparison, the blade member 2 made by the comparison process, and the blade member 1 made by the conventional process, were extremely inferior in this respect, since the surface coating of TiCN on each cermet substrate contained the binder metals of the cermet caused by diffusion. Also, the blade member 1 made by the comparison process was inferior in wear resistance, even though the surface coating of TiCN on the cermet substrate did not essentially contain the binder metals. An adequate surface coating

EP 0 440 157 B1

T A B L E - 1

| Kind of substrate for blade member | | Composition (weight %) | | | | | | | | | |
|---|---|---|---|---|---|---|---|---|---|---|---|
| | | Binder components | | | Hard phase constituting components | | | | | | |
| | | Co | Ni | Al | TiN | TiC | TaC | WC | Mo₂C | NbC | ZrC |
| Cermet | A | 8 | 4 | | 24.9 | 35 | 10 | 10 | 8 | | 0.1 |
| | B | 12 | 6 | | 34 | 20 | 12 | 16 | | | |
| | C | 12 | 6 | 0.1 | 23.8 | 25 | 8 | 15 | 8 | 2 | 0.1 |
| | D | 8 | 6 | — | 30 | 27 | 10 | 10 | 8 | 1 | |

## TABLE-2

| Kind of blade member | | Conditions of surface-coating by a chemical vapor deposition | | | Constituents of surface-coating (weight %) | | | Width of flank wear of blade member during continuous cutting test |
|---|---|---|---|---|---|---|---|---|
| | | temperature (°C) | compositions of reaction gas (volume %) | pressure (Pa(Torr)) | Co | Ni | TiCN | |
| Blade member by this invention | 1 | 700 | TiCl₄ : 4%, CH₃CN : 8%, H₂ : 88% | 13300 (100) | 0.2 | 0.1 | balance | 0.17 |
| | 2 | 750 | | | 0.3 | 0.1 | balance | 0.14 |
| | 3 | 800 | | | 0.5 | 0.3 | balance | 0.12 |
| | 4 | 850 | | | 1.0 | 0.6 | balance | 0.14 |
| | 5 | 900 | | | 1.8 | 1.0 | balance | 0.18 |
| Blade member by comparison process | 1 | 650※ | | | 0.1 | 0.1 | balance | 0.35 |
| | 2 | 950※ | | | 7.6 | 4.0 | balance | 0.48 |
| Blade member by conventional process | 1 | 1000※ | TiCl : 4%, CH₄ : 3%※, N₂ : 4%※, H₂ : 89% | 13300 (100) | | | | |

(※ not falling within the range of this invention )

thickness was not formed on the cermet substrate of the above blade member 1, because of the low temperature during chemical vapor deposition process.

6

EXAMPLE 2

The cermet substrates A and D shown in TABLE 1 were subjected to a chemical vapor deposition process to form a surface coating composed of reaction layers of TiN-TiCN-TiN to produce blade members 6 to 9 according to this invention, and blade members 2 and 3 by the conventional process, as shown in TABLE 3.

In TABLE 3, both reaction layers of TiN on the cermet substrate and on the reaction layer of TiCN according to this invention, were formed by a chemical vapor deposition process using a reaction gas composed of 4% $TiCl_4$, 8% $N_2$ and 88% $H_2$ at a temperature of 900°C. Also, the reaction layer of TiCN between these reaction layers of TiN was formed by a chemical vapor deposition process using reaction gas composed of 4% $TiCl_4$, 8% $CH_3CN$ and 88% $H_2$ at a temperature of 850°C under a pressure of 13300 Pa (100 Torr). On the other hand, the reaction layers of TiN on the cermet substrate and on the reaction layer of TiCN by the conventional process were both formed using reaction gas composed of 4% $TiCl_4$, 8% $N_2$ and 88% $H_2$ at a temperature of 980°C. The reaction layer of TiCN between the reaction layers of TiN was formed using reaction gas composed of 4% $TiCl_4$, 3% $CH_4$, 4% $N_2$ and 89% $H_2$ at a temperature of 1000°C under a pressure of 13300 Pa (100 Torr).

Then, the blade members 6 to 9 produced according to this invention, and the blade members 2 and 3 produced by the conventional process, were subjected to a continuous cutting test under

7

TABLE - 3

| | Kind of cermet substrate | Conditions of surface coating (thickness in mm) | Constituents of surface-coating (weight %) | | | Width of flank wear of blade member during continuous cutting test |
|---|---|---|---|---|---|---|
| | | | Co | Ni | TiCN | |
| Blade member by this invention | 6 | A | TiN(0.5)-TiCN(4.5)-TiN(0.5) | 0.4 | 0.2 | balance | 0.11 |
| | 7 | A | TiN(1.0)-TiCN(3.5)-TiN(0.5) | 0.3 | 0.1 | balance | 0.13 |
| | 8 | D | TiN(0.5)-TiCN(4.5)-TiN(0.5) | 0.4 | 0.2 | balance | 0.10 |
| | 9 | D | TiN(3.0)-TiCN(4.5)-TiN(0.5) | 0.2 | 0.1 | balance | 0.18 |
| Blade member by conventional process | 2 | A | TiN(1.0)-TiCN(3.5)-TiN(0.5) | 5.1 | 2.5 | balance | 0.44 |
| | 3 | D | TiN(4.5)-TiCN(2.0)-TiN(0.5) | 4.0 | 2.1 | balance | 0.50 |

the same cutting conditions as in EXAMPLE 1 to determine wear resistance. After this continuous cutting test, the flank wear of each blade member was observed. The results obtained are shown in TABLE 3.

As seen from TABLE 3, the blade members 6 to 9 obtained by this invention exhibited excellent wear resistance, since the binder metals of the cermet did not essentially diffuse into the reaction layer of TiCN on each cermet substrate, even though the reaction layers of TiN were formed on and under the reaction layer of TiCN by the conventional process. On the other hand, the blade members 2 and 3 produced by conventional process were inferior in this property, since the reaction layer of TiCN formed on each reaction layer of TiN contained a great deal of the binder metals of the cermet caused by the diffusion.

EXAMPLE 3

A surface coating composed of reaction layers of TiN-TiCN-TiN was formed on the cermet substrate C shown in Table 1 by a chemical vapor deposition process to produce a blade member 10 according to this invention. To obtain the blade member 10, a reaction layer of TiN having average thickness of 1 $\mu$m was first formed on the cermet substrate C, using a reaction gas composed of 4% $TiCl_4$, 8% $NH_3$ and 88% $H_2$ at a temperature of 800 °C under the pressure of 13300 Pa (100 Torr). Second, a reaction layer of TiCN having an average thickness of 4 $\mu$m was formed on the reaction layer of TiCN, using reaction gas composed of 4% $TiCl_4$, 8% $CH_3CN$ and 88% $H_2$ at a temperature of 800 °C under the pressure of 13300 Pa (100 Torr). Third, a reaction layer of TiN having an average thickness of 1 $\mu$m was formed on the above reaction layer of TiCN under the same conditions as the above first reaction layer of TiN.

For the purpose of comparison, a surface coating of TiN-TiCN-TiN was formed on the cermet substrate C shown in TABLE 1 by the conventional process to produce a blade member 4. To obtain the blade member 4, a reaction layer of TiN having an average thickness of 1 $\mu$m was formed on the cermet substrate C, using reaction gas composed of 4% $TiCl_4$, 8% $N_2$ and 88% $H_2$ at a temperature of 980 °C under a pressure of 13300 Pa (100 Torr). Second, the reaction layer of TiCN having an average thickness of 4 $\mu$m was formed on the reaction layer of TiCN, using reaction gas composed of 4% $TiCl_4$, 3% $CH_4$, 4% $N_2$ and 89% $H_2$ at a temperature of 1000 °C under a pressure of 13300 Pa (100 Torr). Third, the reaction layer of TiN having an average thickness of 1 $\mu$m was formed on the reaction layer of TiCN under the same conditions as the above first reaction layer of TiN.

Then, the constituents of the surface coating of these blade member 10 according to this invention, and blade member 4 produced by conventional process, were observed under a microscope. Subsequently, these blade member 10 and the blade member 4 were subject to a continuous cutting test under the same cutting conditions as in EXAMPLE 1. After this continuous cutting test, the flank wear of each blade member was observed. The results obtained are shown in TABLE 4.

## TABLE 4

| Kind of blade member | Flank wear during continuous cutting test (mm) |
|---|---|
| Blade member 10 by this invention | 0.12 |
| Blade member 4 by conventional process | 0.58 |

Under the microscope, the diffusion of binder metals of cermet into the surface coating of the blade member 4 by conventional process was seen, though such diffusion could not be seen in the surface coating of the blade member 10 according to this invention. As a result, the blade member 10 according to this invention was highly superior in wear resistance to the blade member 4 by conventional process as seen in TABLE 4.

**Claims**

1. A process for producing a surface-coated blade member for cutting tools, comprising the steps of:
   (a) preparing cermet substrate, wherein
      said cermet substrate contains 70 to 95% carbo-nitride by weight as a hard phase-constituting component,
      said cermet substrate has the formula $(Ti_xM_y)(C_uN_v)$, wherein M is at least one metal selected from the group consisting of metals in groups $IV_A$, $V_A$ and $VI_A$ of the Periodic Table except for titanium, and wherein x, y, u and v are molar ratios, and 0.5≦x≦0.95, 0.05≦y≦0.5, 0.2≦u≦0.8, 0.2≦v≦0.8, x + y = 1 and u + v = 1, and

said cermet substrate contains a binder component of one or two metals selected from the group of cobalt and nickel; and,

(b) forming at least one layer of titanium carbo-nitride by a chemical vapor deposition process on said cermet substrate, wherein

said chemical vapor deposition process is conducted in a temperature range of 700 to 900°C, said chemical vapor deposition process uses a reaction gas containing acetonitrile, and said layer of titanium carbo-nitride has an average thickness of 0.5 to 20 $\mu$m.

2. A process according to claim 1, wherein said reaction gas is a mixture of titanium tetrachloride, acetonitrile and hydrogen gases.

3. A process for producing a surface-coated blade member for cutting tools, comprising the steps of:

(a) preparing cermet substrate, wherein

said cermet substrate contains 70 to 95% carbo-nitride by weight as a hard phase-constituting component,

said cermet substrate has the formula $(Ti_xM_y)(C_uN_v)$, wherein M is at least one metal selected from the group consisting of metals in groups $IV_A$, $V_A$ and $VI_A$ of the Periodic Table except for titanium, and wherein x, y, u and v are molar ratios, and 0.5≦x≦0.95, 0.05≦y≦0.5, 0.2≦u≦0.8, 0.2≦v≦0.8, x + y = 1 and u + v = 1, and

said cermet substrate contains a binder component of one or two metals selected from the group of cobalt and nickel; and,

(b) forming a layer of titanium nitride by a chemical vapor deposition process on said cermet substrate; and,

(c) forming at least one layer of titanium carbo-nitride by a chemical vapor deposition process on said layer of titanium nitride, wherein

said chemical vapor deposition process is conducted in a temperature range of 700 to 900°C, said chemical vapor deposition process uses a reaction gas containing acetonitrile, and said layer of titanium carbo-nitride has an average thickness of 0.5 to 20 $\mu$m.

4. A process according claim 3, wherein said layer of titanium nitride has an average thickness of no greater than 4 $\mu$m.

**Patentansprüche**

1. Verfahren zur Erzeugung eines oberflächenbeschichteten Klingenteils zum Schneiden von Werkzeugen, umfassend die Schritte :

(a) Herstellung eines Cermet-Substrates, worin das Cermet-Substrat 70 bis 95 Gew.% Carbonitrid als eine Komponente enthält, die eine harte Phase ausmacht,

worin das Cermet-Substrat die Formel $(Ti_xM_y)(C_uN_v)$ hat, worin M zumindest ein Metall ist, ausgewählt aus der Gruppe, bestehend aus Metallen der Gruppen $IV_A$, $V_A$ und $VI_A$ des Periodensystems, mit Ausnahme von Titan, und worin x, y, u und v die molaren Verhältnisse sind und bedeuten: 0,5≦x≦0,95, 0,05≦y≦0,5, 0,2≦u≦0,8, 0,2≦v≦0,8, x + y = 1 und u + v = 1; und

worin das Cermet-Substrat eine Bindemittelkomponente aus einem oder zwei Metallen enthält, ausgewählt aus der Gruppe von Cobalt und Nickel; und

(b) Bildung von zumindest einer Schicht aus Titancarbonitrid durch ein chemisches Dampfniederschlagsverfahren auf dem Cermet-Substrat, worin das chemische Dampfniederschlagsverfahren in einem Temperaturbereich von 700 bis 900°C durchgeführt wird, das chemische Dampfniederschlagsverfahren ein Acetonitril-haltiges Reaktionsgas verwendet und die Schicht von Titancarbonitrid eine durchschnittliche Dicke von 0,5 bis 20 $\mu$m hat

2. Verfahren nach Anspruch 1,

worin das Reaktionsgas eine Mischung aus Titantetrachlorid-, Acetonitril- und Wasserstoffgasen ist.

3. Verfahren zur Erzeugung eines oberflächenbeschichteten Klingenteils zum Schneiden von Werkzeugen, umfassend die Schritte:

(a) Herstellung eines Cermet-Substrates, worin das Cermet-Substrat 70 bis 95 Gew.% Carbonitrid als eine Komponente enthält, die eine harte Phase ausmacht,

worin das Cermet-Substrat die Formel $(Ti_xM_y)(C_uN_v)$ hat, worin M zumindest ein Metall ist, ausgewählt aus der Gruppe, bestehend aus Metallen der Gruppen $IV_A$, $V_A$ und $VI_A$ des Periodensystems, mit Ausnahme von Titan, und worin x, y, u und v die molaren Verhältnisse sind und bedeuten: $0,5 \leq x \leq 0,95$, $0,05 \leq y \leq 0,5$, $0,2 \leq u \leq 0,8$, $0,2 \leq v \leq 0,8$, $x + y = 1$ und $u + v = 1$; und

worin das Cermet-Substrat eine Bindemittelkomponente aus einem oder zwei Metallen enthält, ausgewählt aus der Gruppe von Cobalt und Nickel; und

(b) Bildung von zumindest einer Schicht aus Titannitrid durch ein chemisches Dampfniederschlagsverfahren auf dem Cermet-Substrat; und

(c) Bildung von zumindest einer Schicht aus Titancarbonitrid durch ein chemisches Dampfniederschlagsverfahren auf der Schicht aus Titannitrid, wobei das chemische Dampfniederschlagsverfahren in einem Temperaturbereich von 700 bis 900 °C durchgeführt wird, das chemische Dampfniederschlagsverfahren ein Acetonitril-haltiges Reaktionsgas verwendet und die Schicht aus Titancarbonitrid eine durchschnittliche Dicke von 0,5 bis 20 $\mu$m hat.

4. Verfahren nach Anspruch 3,
worin die Schicht aus Titannitrid eine durchschnittliche Dicke von nicht mehr als 4 $\mu$m hat.

**Revendications**

1. Procédé pour fabriquer une lame revêtue en surface pour outils de coupe, comprenant les étapes consistant à :
(a) préparer un substrat de cermet, dans lequel :
- ledit substrat de cermet contient 70 à 95 % de carbo-nitrure en poids comme composant constituant la phase dure;
- ledit substrat de cermet répond à la formule $(Ti_xM_y)(C_uN_v)$, dans laquelle M est au moins un métal choisi dans le groupe constitué des métaux des groupes $IV_A$, $V_A$ et $VI_A$ de la Classification Périodique, à l'exception du titane, et dans laquelle x, y, u et v sont des rapports molaires, et $0,5 \leq x \leq 0,95$, $0,05 \leq y \leq 0,5$, $0,2 \leq u \leq 0,8$, $0,2 \leq v \leq 0,8$, $x + y = 1$, et $u + v = 1$; et
- ledit substrat de cermet contient un composant de liaison en un ou deux métaux choisis dans le groupe constitué du cobalt et du nickel; et
(b) former au moins une couche de carbo-nitrure de titane par un procédé de déposition en phase gazeuse par procédé chimique sur ledit substrat de cermet, où
- ledit procédé de déposition en phase gazeuse par procédé chimique est conduit dans une gamme de température de 700 à 900 °C,
- ledit procédé de déposition en phase gazeuse par procédé chimique utilise un gaz réactionnel contenant de l'acétonitrile, et
- ladite couche de carbo-nitrure de titane a une épaisseur moyenne de 0,5 à 20 $\mu$m.

2. Procédé selon la revendication 1, dans lequel ledit gaz réactionnel est un mélange de tétrachlorure de titane, d'acétonitrile et d'hydrogène gazeux.

3. Procédé pour fabriquer une lame revêtue en surface pour outils de coupe, comprenant les étapes consistant à :
(a) préparer un substrat de cermet, dans lequel :
- ledit substrat de cermet contient 70 à 95 % de carbo-nitrure en poids comme composant constituant la phase dure;
- ledit substrat de cermet répond à la formule $(Ti_xM_y)(C_uN_v)$, dans laquelle M est au moins un métal choisi dans le groupe constitué des métaux des groupes $IV_A$, $V_A$ et $VI_A$ de la Classification Périodique, à l'exception du titane, et dans laquelle x, y, u et v sont des rapports molaires, et $0,5 \leq x \leq 0,95$, $0,05 \leq y \leq 0,5$, $0,2 \leq u \leq 0,8$, $0,2 \leq v \leq 0,8$, $x + y = 1$, et $u + v = 1$; et
- ledit substrat de cermet contient un composant de liaison en un ou deux métaux choisis dans le groupe constitué du cobalt et du nickel; et
(b) former une couche de carbo-nitrure de titane par un procédé de déposition en phase gazeuse par procédé chimique sur ledit substrat de cermet, et
(c) former au moins une couche de carbo-nitrure de titane par un procédé de déposition en phase gazeuse par procédé chimique sur ladite couche de nitrure de titane, où

- ledit procédé de déposition en phase gazeuse par procédé chimique est conduit dans une gamme de température de 700 à 900°C,
- ledit procédé de déposition en phase gazeuse par procédé chimique utilise un gaz réactionnel contenant de l'acétonitrile, et
- ladite couche de carbo-nitrure de titane a une épaisseur moyenne de 0,5 à 20 μm.

4.  Procédé selon la revendication 3, dans lequel ladite couche de nitrure de titane a une épaisseur moyenne non supérieure à 4 μm.